# EUROPEAN PATENT SPECIFICATION

(11) **EP 2 922 197 B1**
(45) Date of publication and mention of the grant of the patent: **30.10.2019**
(21) Application number: 13854732.8
(22) Date of filing: 14.11.2013
(51) Int. Cl.: H02S 30/10, H02S 40/34, F24S 25/20

(54) **SOLAR CELL MODULE**
SOLARZELLENMODUL
MODULE DE CELLULE SOLAIRE

(30) Priority: 14.11.2012 JP 2012250259
(43) Date of publication of application: 23.09.2015
(73) Proprietor: Panasonic Intellectual Property Management Co., Ltd., Osaka-shi, Osaka 540-6207 (JP)
(72) Inventor: FUKUMOCHI, Shuji, Osaka-shi, Osaka (JP)
(74) Representative: Klunker IP Patentanwälte PartG mbB
(86) International application number: PCT/JP2013/006693
(87) International publication number: WO 2014/076952

(56) References cited:
- EP-A1- 1 763 088
- EP-A2- 2 423 975
- JP-A- H11 330 524
- JP-A- 2001 339 087
- JP-A- 2006 286 838
- JP-A- 2007 081 034
- JP-A- 2007 095 819
- JP-A- 2010 192 854

## Description

### TECHNICAL FIELD

The present invention relates to a solar cell module.

### BACKGROUND ART

Both JP 2007-81034 A and JP 2007-95819 A disclose a solar cell module in which a terminal box is installed on a rear surface side of a solar cell panel. More specifically, JP 2007-81034 A discloses a structure in which a terminal box is attached to a substrate on a rear surface side of a solar cell panel using an adhesive. JP 2007-95819 A discloses a structure in which an opening space is provided in a portion of a frame, and a terminal box is fitted into this space. For example, the structure disclosed in JP 2007-95819 A exhibits excellent stability in fixation of the terminal box, but its frame structure is complex.

EP 2 423 975 A2 discloses a solar cell with a first substrate including a first region and a second region adjacent to the first region, a plurality of solar cells in the first region, and a second substrate provided in the first region to expose the second region and provided on the solar cells.

EP 1 763 088 A1 discloses a photovoltaic module for preventing insulation failure between an outer frame and connection leads. The photovoltaic module comprises: a photovoltaic submodule including a plurality of solar cells interposed between two light-transmitting substrates through the intermediary of an encapsulant and the connection leads extending from an edge between light-transmitting substrates and outputting generated electric currents; a terminal box attached near an edge of the photovoltaic submodule and housing connected parts between the connection leads and cables for outputting the electric currents to the outside; and an outer frame fitting over peripheral edges of the photovoltaic submodule. A side, of the light-receiving side light-transmitting substrate, from which the connection leads are pulled out, is made large so as to extend outward further than the other light-transmitting substrate. The connection leads are led out from the edge between the two light-transmitting substrates to be guided into the terminal box.

### SUMMARY OF THE INVENTION

### PROBLEMS TO BE SOLVED BY THE INVENTION

In a solar cell module, fire resistance is required. For example, if fire sparks fall onto the light-receiving surface in the event of a fire or the like, the terminal box may possibly drop due to the resulting heat. For this reason, it is an object of the present invention to provide a solar cell module, in which such dropping of the terminal box is prevented by a simple method.

### MEANS FOR SOLVING THE PROBLEMS

The object is achieved by the features of the independent claim. Further embodiments are defined in the dependent claims.

A solar cell module according to the present invention comprises a solar cell panel, a terminal box installed on a rear surface side of the solar cell panel, and a frame attached to an outer edge of the solar cell panel and having a flange part covering a portion of a light-receiving surface of the panel, the portion being located above the terminal box.

### ADVANTAGES OF THE INVENTION

According to the solar cell module of the present invention, fire resistance can be enhanced by a simple method.

### BRIEF DESCRIPTION OF THE DRAWINGS

FIG. 1 is a plan view of a solar cell module according to an embodiment of the present invention, as seen from a light-receiving surface side.
FIG. 2 is a cross-sectional view taken along line A-A in FIG. 1.
FIG. 3 is an enlarged view of portion B in FIG. 2.
FIG. 4 is an enlarged view of portion C in FIG. 2.
FIG. 5 is a cross-sectional view showing a solar cell module according to another embodiment of the present invention.
FIG. 6 is a cross-sectional view showing a solar cell module according to another embodiment of the present invention.
FIG. 7 is a cross-sectional view showing a solar cell module according to another embodiment of the present invention.
FIG. 8 is a cross-sectional view showing a solar cell module according to another embodiment of the present invention.
FIG. 9 is a cross-sectional view showing a solar cell module according to another embodiment of the present invention.
FIG. 10 is a cross-sectional view showing a solar cell module according to another embodiment of the present invention.

### EMBODIMENTS OF THE INVENTION

Embodiments according to the present invention are described in detail with reference to the drawings. The present invention is not limited to the following embodiments. Further, the drawings referred to in connection with the embodiments are depicted schematically, so that the dimensional ratios and the like of the constituent elements illustrated in the drawings may differ from the actual elements. The specific dimensional ratios and the like should be determined in consideration of the following descriptions.

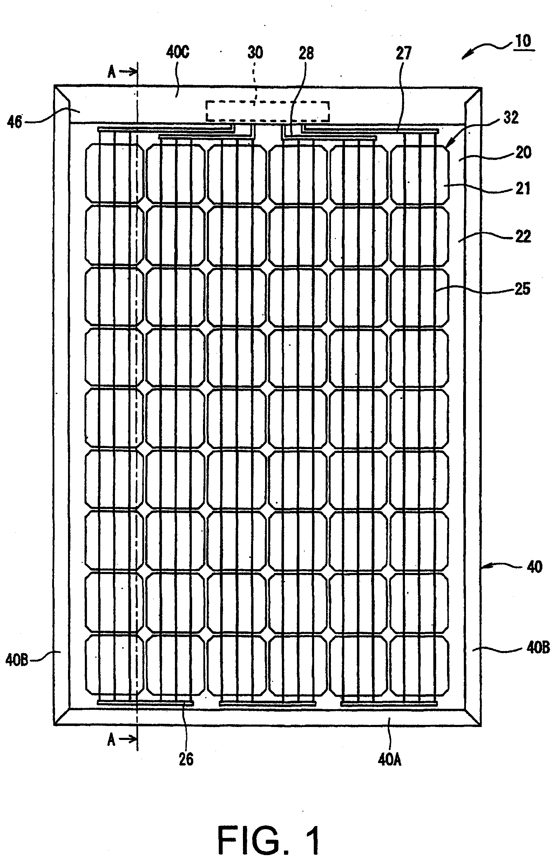

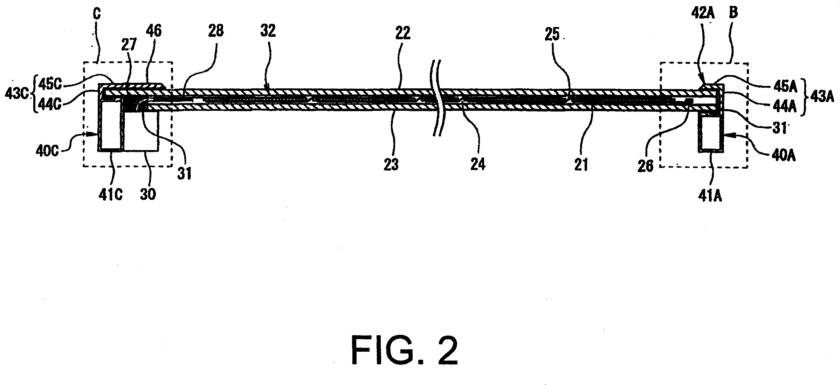

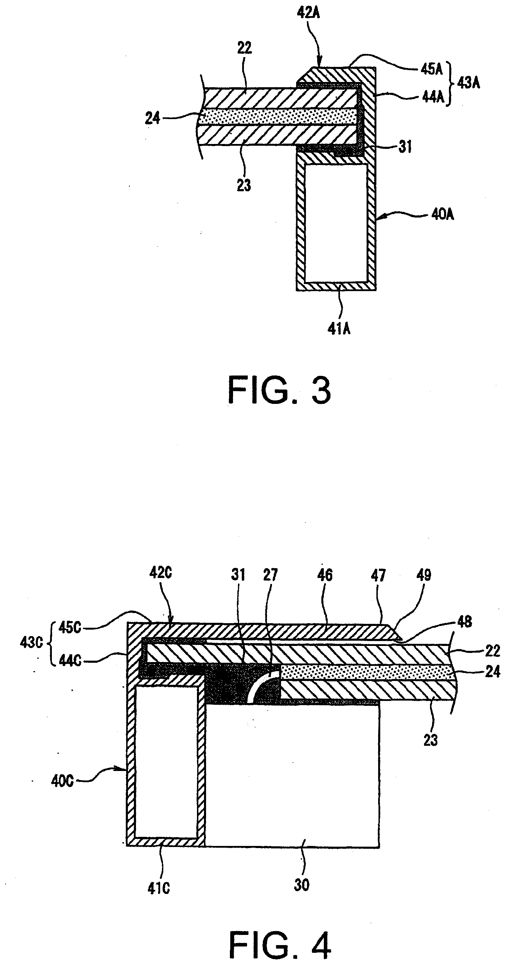

FIG. 1 is a plan view of a solar cell module 10 according to an embodiment of the present invention, as seen from a light-receiving surface side. FIG. 2 is a cross-sectional view taken along line A-A in FIG. 1. FIG. 3 is an enlarged view of portion B (portion in the vicinity of frame 40A) in FIG. 2. FIG. 4 is an enlarged view of portion C (portion in the vicinity of frame 40C) in FIG. 2. Here, a "light-receiving surface" denotes a surface, among the surfaces of solar cell elements 21, on which solar light is mainly incident. A "rear surface" is a surface located on the opposite side of the light-receiving surface. In other words, the rear surface corresponds to the surface having a large area in which an electrode described below is formed, or the surface having the electrode if the electrode is formed only on one of the surfaces.

The solar cell module 10 comprises a solar cell panel 20, a terminal box 30 installed on the rear surface side of the solar cell panel 20, and a frame 40 attached to outer edges of the solar cell panel 20. The solar cell panel 20 shown in FIG. 1 has a rectangular shape in plan view. Frames 40A and 40C are attached to the outer edges of the short sides, while frames 40B are attached to the outer edges of the long sides. Here, "plan view" denotes a planar shape as viewed from a direction perpendicular to the light-receiving surface.

The solar cell panel 20 includes a plurality of solar cell elements 21, a first protective member 22 provided on the light-receiving surface side of the solar cell elements 21, and a second protective member 23 provided on the rear surface side of the solar cell elements 21. The plurality of solar cell elements 21 are held between the first protective member 22 and the second protective member 23, and sealed with a encapsulant 24.

The solar cell panel 20 includes wiring members 25 attached to electrodes of the solar cell elements 21. The wiring members 25 serially connect between adjacent solar cell elements 21 to thereby form a string 32. A plurality of strings 32 are arranged in an array such that, with respect to the direction of arrangement of the plurality of solar cell elements 21 connected by the wiring members 25, the array extends along a perpendicular direction within the same plane.

The solar cell panel 20 further includes a first crossover wiring member 26 connecting between the wiring member 25 portions located at respective ends of adjacent strings 32, and a second crossover wiring member 28 which connects between the wiring member 25 portions located at respective ends of adjacent strings 32 and which also connects to the terminal box 30. The second crossover wiring member 28 is drawn out of the solar cell panel 20 and is connected to a bypass diode (not shown) provided in the terminal box 30. The solar cell panel 20 further includes output wiring members 27 provided at respective ends of the strings 32 positioned at two edges. The output wiring members 27 are attached to the wiring member 25 portions located at respective ends of the strings 32 positioned at the two edges, and are drawn out of the solar cell panel 20 as negative and positive terminals, to be connected to the terminal box 30.

Each solar cell element 21 includes a photoelectric conversion part that generates carriers upon receiving solar light. The photoelectric conversion part includes, for example, a light-receiving-surface electrode formed on its light-receiving surface and a rear-surface electrode formed on its rear surface (both not shown). Structure of the solar cell element 21 is not particularly limited, and may be such that the electrode is formed only on the rear surface of the photoelectric conversion part.

The photoelectric conversion part includes, for example, a semiconductor substrate composed of a material such as crystalline silicon (c-Si), gallium arsenide (GaAs), or indium phosphide (InP), an amorphous semiconductor layer formed on the substrate, and a transparent conductive layer formed on the amorphous semiconductor layer. In a specific example, a structure may be provided in which, on the light-receiving surface of an n-type monocrystalline silicon substrate, an i-type amorphous silicon layer, a p-type amorphous silicon layer, and a transparent conductive layer are sequentially formed, and on the rear surface, an i-type amorphous silicon layer, an n-type amorphous silicon layer, and a transparent conductive layer are sequentially formed. The transparent conductive layer is preferably composed of a transparent conductive oxide prepared by doping a metal oxide such as indium oxide (In₂O₃) or zinc oxide (ZnO) with tin (Sn), antimony (Sb) or the like.

The electrode is composed of a plurality of finger parts and a plurality of bus bar parts, for example. The finger parts are narrow, filamentous electrodes formed over a wide area on the transparent conductive layer. The bus bar parts are electrodes for collecting carriers from the finger parts . The wiring members 25 are attached to the bus bar parts.

As the first protective member 22, it is possible to use a material having translucency, such as a glass substrate, a resin substrate, or a resin film. Among these materials, a glass substrate is preferred considering fire resistance, durability, and the like. As the second protective member 23, the same material as the first protective member 22 may be used, or alternatively, a material that does not have translucency may be used when light incidence from the rear surface side is not intended. In the present embodiment, a glass substrate having translucency is used for both the first protective member 22 and the second protective member 23. As the encapsulant 24, a resin such as ethylene-vinyl acetate copolymer (EVA) or polyvinyl butyral (PVB) may be used.

The terminal box 30 includes respective terminal blocks corresponding to each of the output wiring members 27 and the second crossover wiring members 28. The output wiring members 27 and the second crossover wiring members 28 drawn into the terminal box 30 are each attached to corresponding terminal blocks by a method such as soldering. Power lines for outputting electric power from the module are attached to the terminal blocks for connecting the output wiring members 27. Further, bypass diodes are connected between the terminal blocks so that when the output wiring members 27 and the second crossover wiring members 28 are attached in place, the bypass diodes electrically connect the output wiring members 27 with the second crossover wiring members 28, and also connect the second crossover wiring members 28 with each other. With this arrangement, the module is configured to output electric power stably even when output from some of the strings has dropped.

The terminal box 30 is installed on the rear surface side of the solar cell panel 20 at an outer edge along a short side (hereinafter referred to as "outer edge C") of the solar cell panel 20. The terminal box 30 is attached to the rear surface of the solar cell panel 20 using an adhesive 31, for example. As the adhesive 31, a silicone resin type adhesive is preferably used, and this adhesive may be the same adhesive as that used to fix the solar cell panel 20 to the frame 40, which is described later. The shape of the terminal box 30 is not particularly limited, and is a substantially cuboid shape, for example. Preferably, the terminal box 30 is attached with its lengthwise direction being parallel to the short side of the solar cell panel 20 and contacting an inner side of the frame 4C. In that case, the terminal box 30 may be screwed to the frame 40C.

The frame 40 is constituted by combining three types of frames 40A, 40B, and 40C as mentioned above, and surrounds the four sides of the solar cell panel 20. The solar cell panel 20 is fixed to the frame 40 by being fitted into a recess part described later and by using an adhesive 31. The frame 40 is a metallic frame composed of a material such as stainless steel or aluminum, and is preferably made of aluminum considering light weight property and the like. The frame 40 protects the outer edges of the solar cell panel 20, and serves as a fixing member when installing the solar cell module 10 on a roof or the like. Further, when the frame 40 is positioned contacting the terminal box 30, the frame 40 is also used for dissipating heat from the diodes contained inside the terminal box 30.

The frame 40A is a frame attached to the outer edge located on the opposite side of the outer edge C of the solar cell panel 20, and includes a body part 41A having a hollow structure, and a recess part 42A into which the outer edge of the solar cell panel 20 is fitted. The body part 41A has a cavity extending in the lengthwise direction. Further, its cross-section obtained by cutting along a direction orthogonal to the lengthwise direction has a substantially rectangular shape that is somewhat elongated in the vertical direction. Hereinafter, unless specified otherwise, a "cross-section" of a frame denotes a cross-section obtained by cutting along a direction orthogonal to the lengthwise direction. Further, a "vertical direction" of a frame denotes a direction along the thickness of the solar cell panel 20, with the light-receiving surface side being the "upper" side, and the rear surface side being the "lower" side. Furthermore, a "width direction" denotes a direction that is within a cross-section orthogonal to the lengthwise direction of the frame 40A and that is orthogonal to the vertical direction.

The recess part 42A is constituted with a hold-down part 43A having an L-shaped cross-section, which is provided on top of the body part 41A. The hold-down part 43A includes a first component 44A extending in the vertical direction and forming a surface coplanar with the surface of the body part 41A at the outer side of the frame 40A, and a second component 45 extending in the width direction from an upper end of the first component 44A. Between the second component 45A and the upper surface of the body part 41, there is formed a groove into which the solar cell panel 20 can be fitted from the inner side. The second component 45B covers the light-receiving surface of the solar cell panel 20 fitted in place, and contacts the light-receiving surface via the adhesive 31. Here, the width direction size of the second component 45B is approximately the same as the width direction size of the body part 41A, and the second component 45B covers only a portion of the light-receiving surface of the solar cell panel 20 that is located on top of the body part 41A.

The frames 40B are attached to the outer edges of the long sides of the solar cell panel 20. Each frame 40B has a structure identical to the frame 40A except that the length is longer than the frame 40A. The frames 40A, 40B are connected to each other using, for example, a corner piece (not shown) that is press-fitted into the cavities of the body parts . The frames 40B, 40C are also fixed to each other in a similar way. The two ends in the lengthwise direction of each frame 40A, 40B, 40C are cut diagonally, and the angle of inclination of the respective end faces formed at those two ends with respect to the lengthwise direction is preferably approximately 45 degrees. Each frame 40A, 40B, 40C is cut in a trapezoid shape (in plan view) that tapers toward the inner side, in a manner such that the respective end faces in the lengthwise direction of the frames match one another at the connecting portions.

In the present embodiment, at all outer edges of the solar cell panel 20 except for the outer edge C, the edge of the first protective member 22 and the edge of the second protective member 23 match each other. Specifically, the recess part of each frame 40A, 40B is formed so as to define a groove into which the first protective member 22, the second protective member 23, the encapsulant 24 held therebetween, and the like can be fitted. On the other hand, in the present embodiment, at the outer edge C, the surface of the first protective member 22 on the rear surface side is exposed beyond the edge of second protective member 23. In other words, at the outer edge C, the first protective member 22 has a length longer than the second protective member 23. A recess part 42C of the frame 40C defines a groove into which the first protective member 22 can be fitted, and this groove is narrower than the recess part of the frame 40A, 40B.

The frame 40C is attached to the outer edge C of the solar cell panel 20. Similar to the frames 40A, 40B, the frame 40C includes a body part 41C and a recess part 42C, and the recess part 42C is constituted with a hold-down part 43C provided on top of the body part 41C. However, the first component 44C of the hold-down part 43C has a length shorter than the first component 44A, and, as mentioned above, the gap between the second component 45C of the hold-down part 43C and the upper surface of the body part 41C is narrower than in the case of the recess part 42A.

The frame 40C includes a flange part 46 covering a portion of the light-receiving surface of the solar cell panel 20 that is located above the terminal box 30. Preferably, the flange part 46 is formed so that the terminal box 30 cannot be seen in plan view of the solar cell module 10 obtained from immediately above the frame 40C. Since the terminal box 30 is attached contacting a surface of the body part 41C facing toward the inside of the solar cell module 10 as mentioned above, the flange part 46 projects significantly toward the inner side beyond the body part 41C. Considering heat insulation property and the like, it is preferable to not provide any adhesive 31 between the flange part 46 and the solar cell panel 20, and to configure such that the flange part 46 is not adhered to the light-receiving surface. For example, a small gap is present between the flange part 46 and the solar cell panel 20, or alternatively, the flange part 46 is substantially in contact with the light-receiving surface without any gap being present therebetween.

The flange part 46 is formed integrally with the recess part 42C and projecting from the recess part 42C. More specifically, the flange part 46 is formed integrally with the second component 45C of the hold-down part 43C constituting the recess part 42C. In the present embodiment, the second component 45C and the flange part 46 have the same thickness, and the flange part 46 extends straight along the width direction, as with the second component 45C. In other words, it can be said that, in the frame 40C, the second component 45C projects and overhangs the terminal box 30. For the convenience of description, the part projecting beyond the body part 41C toward the center of the solar cell module 10 is referred to as the flange part 46. Although the flange part 46 can be configured as a component separate from the frame 40C and may be, for example, attached directly on the light-receiving surface of the solar cell panel 20, it is preferable to form the flange part 46 integrally with the frame 40C considering designability and heat insulating property.

The flange part 46 may be formed only at a central portion along the lengthwise direction of the frame 40C to which the terminal box 30 is attached, or alternatively, as shown in FIG. 1, the flange part 46 may be formed having a length allowing contact with the frames 40B located on both sides. Considering designability and the like, the latter is preferred. The flange part 46 shown in FIG. 1 has a rectangular shape in plan view. Preferably, the flange part 46 is formed so as to avoid, as much as possible, covering the solar cell elements 21 as well as the output wiring members 27 and the second crossover wiring members 28, considering designability and the like. In other words, the width direction size of the flange part 46 is preferably set such that the flange part 46 provides a cover over the terminal box 30 but does not cover the output wiring members 27 and the second crossover wiring members 28 located between the solar cell elements 21 and the terminal box 30.

The flange part 46 has a tip face 49 that is inclined in a manner such that a lower face 48 extends longer than an upper face 47. The angle of inclination of the tip face 49 is not particularly limited, and may be approximately 45 degrees, for example. The tip face 49 is preferably inclined along the entire length of the flange part 46. By forming the tip face 49 to be inclined, generation of shadow due to thickness of the flange part 46 can be minimized. In the frames 40A, 40B too, the tip faces of the hold-down parts are preferably inclined (see FIG. 2).

According to the solar cell module 10 having the above-described configuration, as the flange part 46 of the frame 40C covers and protects the terminal box 30, when fire sparks fall onto the module in case of a fire or the like, heat thereof is less easily conducted to the terminal box 30. As a result, melting or the like of the adhesive 31 fixing the terminal box 30 can be minimized, so that dropping of the terminal box can be prevented. In other words, according to the solar cell module 10, fire resistance can be enhanced using a simple structure.

Moreover, as the flange part 46 hides the terminal box 30 so that the terminal box 30 cannot be seen from the light-receiving surface side, designability of the solar cell module 10 is enhanced.

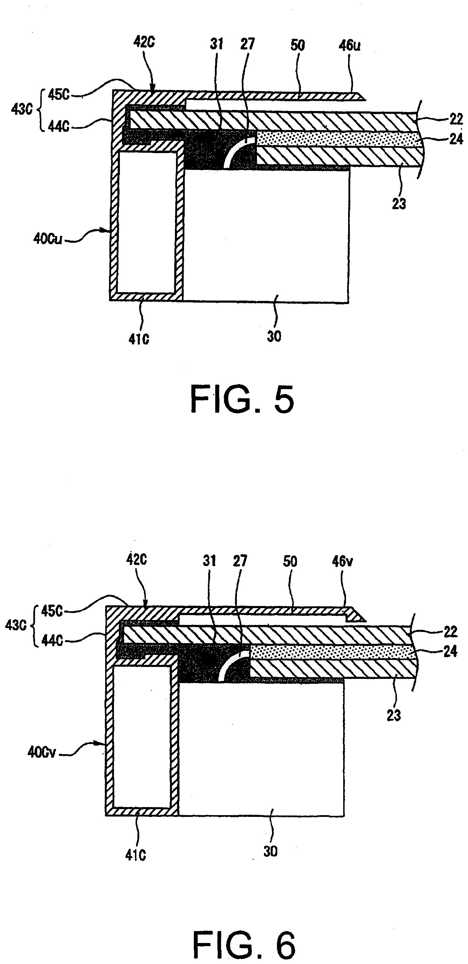

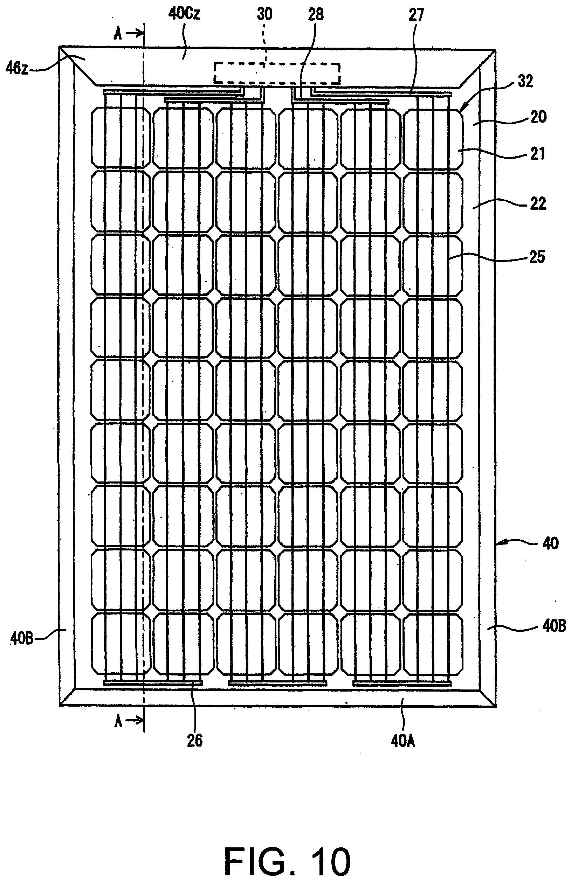

Further embodiments of the present embodiment are described below with reference to FIGs. 5 to 9 (drawings corresponding to FIG. 4) and FIG. 10 (drawing corresponding to FIG. 1). In the following description, constituent elements identical to those in the above-described embodiment are labeled with the same reference symbols, and explanation thereof is not repeated. Only the differences from the above-described embodiment are explained in detail.

The embodiment shown in FIG. 5 differs from the above-described embodiment in that the flange part 46u comprises a thin part 50 having a thickness smaller than the recess part 42C. More specifically, the flange part 46u is formed thinner than the second component 45C of the hold-down part 43C constituting the recess part 42C. In the flange part 46u shown in FIG. 5, its entirety from the base portion abutting the second component 45C to the tip portion is formed as the thin part 50.

In the thin part 50, its upper surface is formed coplanar with the upper surface of the second component 45C. The thin part 50 is formed thin by removing some constituent material on the lower surface side. With this arrangement, a large gap is formed between the thin part 50 and the solar cell panel 20. Although a gap may be formed between the flange part 46u and the solar cell panel 20 in the above-described embodiment, such a gap is smaller than that shown in FIG. 5. Accordingly, compared to the above-described embodiment, the present embodiment is such that heat insulation effect is higher, and heat of fire sparks is less easily conducted to the terminal box 30, so that dropping of the terminal box 30 can be prevented more reliably. Preferably, the thin part 50 is formed thin within a range of thickness that presents no problem with regard to mechanical strength.

The embodiment shown in FIG. 6 differs from the embodiment shown in FIG. 5 in that, at the tip portion of the flange part 46v, the gap formed with respect to the solar cell panel 20 is narrower than at the mid portion. More specifically, only the tip portion is formed having a larger thickness, so that, at this portion, the gap with respect to the solar cell panel 20 is smaller than at the thin part 50. The tip portion may be formed having a further larger thickness so as to be in contact with the solar cell panel 20, or alternatively, the entirety of the flange part 46v may be formed thin (as in the embodiment of FIG. 5) with the tip portion being bent toward the solar cell panel 20. With this arrangement, even when the flange part 46v is formed thin so as to provide a large gap with respect to the solar cell panel 20, it is possible to prevent ingress of foreign substances such as water and dust, and also to avoid defects such as curling up of the flange part 46v.

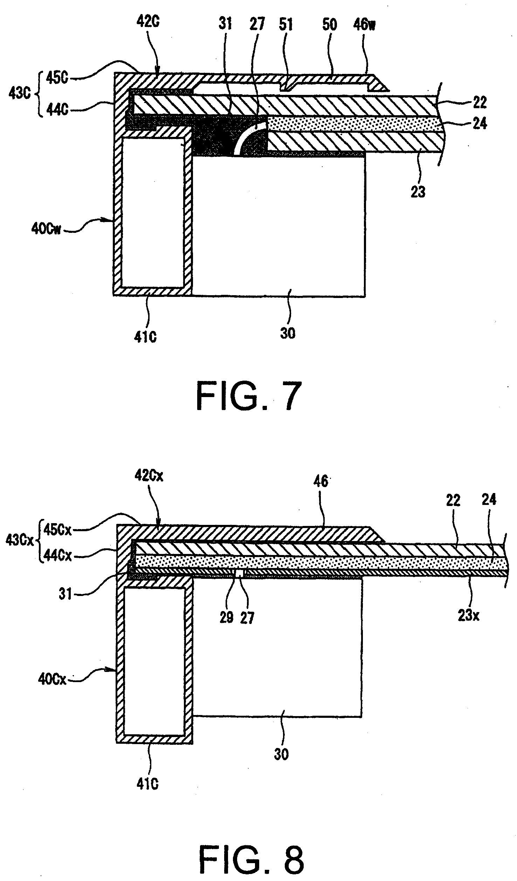

In the flange part 46w shown in FIG. 7, a rib 51 is provided by thickening a portion of the thin part 50 of the flange part 46v. For example, the rib 51 is formed along the lengthwise direction of the frame 40Cw in a center portion in the width direction of the flange part 46w. On both sides of the rib 51 in the width direction, the thin part 50 is formed. By providing the rib 51, an amount of deformation of the flange part 46w can be reduced, so that, for example, it becomes possible to form the thin part 50 to have a further smaller thickness. Further, an end face of the rib 51 facing toward the center of the solar cell module is preferably inclined in a manner such that the rib 51 width becomes narrower toward the bottom. With this arrangement, the solar cell panel 20 can be fitted in smoothly without being caught by the rib 51. Moreover, an end face at a lower part of the second component 45C facing toward the center of the solar cell module is also preferably inclined in a similar manner to the rib 51. For example, this inclined structure may be formed by increasing the thickness of the thin part 50 toward the hold-down part 43C.

The embodiment shown in FIG. 8 differs from the above-described embodiment in that the second protective member 23x is a resin sheet having a thickness smaller than a glass substrate. Furthermore, the first protective member 22 and the second protective member 23x have the same lengths at the outer edge C of the solar cell panel 20, and the recess part 42Cx of the frame 40Cx is fitted with the first protective member 22, the second protective member 23x, the encapsulant 24 held therebetween, and the like. Accordingly, the length of the first component 44Cx of the frame 40Cx is identical to the first components 44a and 44b of the frames 40A and 40B. Further, a through hole 29 is formed in the second protective member 23x. Via the through hole 29, the output wiring member 27 and the second crossover wiring member 28 are drawn out from the solar cell panel 20 and connected to the terminal box 30. Other structural features of the frame 40Cx are the same except that the first component 44Cx has a thickness larger than the first component 44C of the frame 40C in the above-described embodiment shown in FIG. 4.

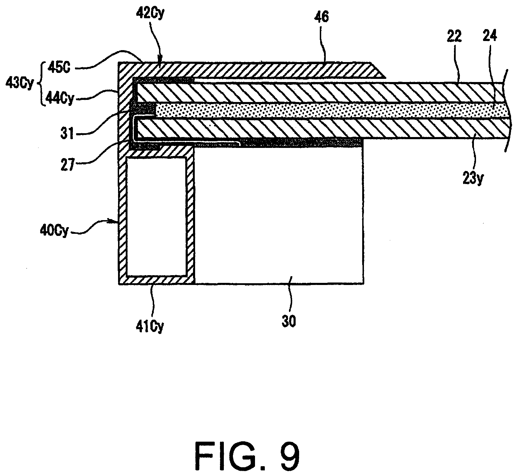

The embodiment shown in FIG. 9 differs from the above-described embodiment in that the first protective member 22 and the second protective member 23y have the same lengths at the outer edge C of the solar cell panel 20, and, as with the recess part 42A, the recess part 42Cy includes a groove that can be fitted with the first protective member 22, the second protective member 23y, the encapsulant 24 held therebetween, and the like. Compared to the frame 40C, the frame 40Cy is configured such that the first component 44Cy has a longer vertical length. In other words, the frame 40Cy shown in FIG. 9 has a structure obtained by providing the flange part 46 on the frame 40A. Further, the output wiring member 27 and the second crossover wiring member 28 are routed along the periphery of the second protective member 23y and through the recess part 42Cy, and connected to the terminal box 30. In this case, an insulating coating is preferably formed on the outer periphery of the output wiring member 27 and the second crossover wiring member 28.

The flange part 46z shown in FIG. 10 has a trapezoid shape (in plan view) that tapers toward the inside. The overall frame 40Cz including the flange part 46z also has a trapezoid shape. While the two ends of the frame 40Cz in the lengthwise direction are cut at an angle of approximately 45 degrees, for example, with respect to the lengthwise direction as described above, the two ends of the flange part 46z in the lengthwise direction are also cut at an angle of approximately 45 degrees together with the body part and the recess part. The frame 40Cz has the same structure as the frame 40C except that the shapes of the two ends of the flange part in the lengthwise direction are different.

There may be various other embodiments in addition to the embodiments shown in FIGs. 5 to 10. For example, the flange part with the reduced thickness shown in FIGs. 5 to 7 may be applied to the embodiments shown in FIGs. 8 and 9. Further, a plurality of terminal boxes 30 may be installed in one module, and the flange part 46 may be formed on a plurality of the frames. Furthermore, the body part 41A of each frame may include a locking part that engages a metal fixture for fixing the solar cell module on a pedestal.

### LIST OF REFERENCE SYMBOLS

10 solar cell module; 20 solar cell panel; 21 solar cell element; 22 first protective member; 23 second protective member; 24 encapsulant; 25 wiring member; 26 first crossover wiring member; 27 output wiring member; 28 second crossover wiring member; 29 through hole; 30 terminal box; 31 adhesive; 32 string; 40, 40A, 40B, 40C frame; 41A, 41C body part; 42A, 42C recess part; 43A, 43C hold-down part; 44A, 44C first component; 45A, 45C second component; 46 flange part; 47 upper face; 48 lower face; 49 tip face; 50 thin part; 51 rib.

## Claims

1. A solar cell module (10), comprising:
a solar cell panel (20);
a terminal box (30) installed on a rear surface side of the solar cell panel (20); and
a frame (40) attached to an outer edge of the solar cell panel (20) and having a recess part (42C; 42Cx; 42Cy) into which the solar cell panel (20) is fitted and a flange part (46; 46u; 46w; 46v) which is arranged above a light-receiving surface of the solar cell panel (20) and formed integrally with the recess part (42C; 42Cx; 42Cy) ;
**characterized in that** the flange part (46; 46u; 46w; 46v) projects from the recess part (42C; 42Cx; 42Cy) covering an entire portion of a light-receiving surface of the panel (20), the portion being located above the terminal box (30), and
that a part of the solar cell panel (20) is fitted between the flange part (46; 46u; 46w; 46v) and the terminal box (30), and another part of the solar cell panel (20) is fitted into the recess part (42C; 42Cx; 42Cy).

2. The solar cell module (10) according to claim 1, wherein
the flange part (46u; 46w; 46v) includes a thin part (50) having a thickness smaller than the recess part (46u; 46w; 46v) ; and
a gap is formed between the thin part (50) and the solar cell panel (20).

3. The solar cell module (10) according to any one of claims 1 or 2, wherein the flange part has a tip portion in contact with the solar cell panel (20), or the flange part (46; 46u; 46w; 46v) is such that a gap formed with respect to the solar cell panel (20) is narrower at the tip portion compared to at a mid portion.

4. The solar cell module (10) according to any one of claims 1 to 3, wherein the flange part (46; 46u; 46w; 46v) has a tip face (49) that is inclined in a manner such that a lower face (48) extends longer than an upper face (47).

## Patentansprüche

1. Solarzellenmodul (10) mit:
einem Solarzellen-Panel (20);
einer Anschlussbox (30), die auf einer Rückoberflächen-Seite des Solarzellen-Panels (20) installiert ist; und
einem Rahmen (40), der an eine äußere Kante des Solarzellenpanels (20) angefügt ist und aufweist einen Ausnehmungsteil (42C; 42Cx; 42Cy), in den das Solarzellenpanel (20) eingepasst ist, und einen Flanschteil (46; 46u; 46w; 46v), der über einer Licht empfangenden Oberfläche des Solarzellenpanels (20) angeordnet ist und integral mit dem Ausnehmungsteil (42C; 42Cx; 42Cy) gebildet ist;
**dadurch gekennzeichnet,**
**dass** der Flanschteil (46; 46u; 46w; 46v) von dem Ausnehmungsteil (42C; 42Cx; 42Cy) einen gesamten Teil einer Licht empfangenden Oberfläche des Panels (20) abdeckend auskragt, wobei der Teil sich über der Anschlussbox (30) befindet, und
**dass** ein Teil des Solarzellenpanels (20) zwischen den Flanschteil (46; 46u; 46w; 46v) und der Anschlussbox (30) eingepasst ist und ein anderer Teil des Solarzellenpanels (20) in den Ausnehmungsteil (42C; 42Cx; 42Cy) eingepasst ist.

2. Solarzellenmodul (10) gemäß Anspruch 1, wobei
der Flanschteil (46u; 46w; 46v) einen dünnen Teil (50) mit einer Dicke kleiner als der Ausnehmungsteil (46u; 46w; 46v) aufweist; und
ein Spalt zwischen dem dünnen Teil (50) und dem Solarzellenpanel (20) gebildet ist.

3. Solarzellenmodul (10) gemäß einem der Ansprüche 1 oder 2, wobei der Flanschteil einen Spitzenabschnitt in Kontakt mit dem Solarzellenpanel (20) aufweist, oder der Flanschteil (46; 46u; 46w; 46v) derart ist, dass ein Spalt, der mit Bezug auf das Solarzellenpanel (20) gebildet ist, am Spitzenabschnitt im Vergleich zu einem Mittelabschnitt schmaler ist.

4. Solarzellenmodul (10) gemäß einem der Ansprüche 1 bis 3, wobei der Flanschteil (46; 46u; 46w; 46v) eine Spitzen-Vorderseite (49) aufweist, die in einer Weise geneigt ist, dass eine untere Vorderseite (48) länger als eine obere Vorderseite (47) ist.

## Revendications

1. Module de cellule solaire (10), comprenant :
un panneau de cellule solaire (20) ;
une boîte à bornes (30) installée sur un côté de surface arrière du panneau de cellule solaire (20), et
un cadre (40) rattaché à un bord extérieur du panneau de cellule solaire (20) et présentant une partie de retrait (42C; 42Cx; 42Cy) où est monté le panneau de cellule solaire (20), et une partie de bride (46; 46u; 46w; 46v), laquelle est agencée au-dessus d'une surface de réception de lumière du panneau de cellule solaire (20) et formée d'un seul tenant avec la partie de retrait (42C; 42Cx; 42Cy) ;
**caractérisé en ce que** la partie de bride (46; 46u; 46w; 46v) fait saillie à partir de la partie de retrait (42C; 42Cx; 42Cy) couvrant toute une portion d'une surface de réception de lumière du panneau (20), la portion se trouvant au-dessus de la boîte à bornes (30), et
**en ce qu'**une partie du panneau de cellule solaire (20) est montée entre la partie de bride (46; 46u; 46w; 46v) et la boîte à bornes (30), et une autre partie du panneau de cellule solaire (20) est montée dans la partie de retrait (42C; 42Cx; 42Cy).

2. Module de cellule solaire (10) selon la revendication 1, dans lequel la partie de bride (46u; 46w; 46v) inclut une partie mince (50) présentant une épaisseur plus petite que la partie de retrait (46u; 46w; 46v), et
un espace est formé entre la partie mince (50) et le panneau de cellule solaire (20).

3. Module de cellule solaire (10) selon la revendication 1 ou 2, dans lequel la partie de bride présente une portion de pointe en contact avec le panneau de cellule solaire (20), ou la partie de bride (46; 46u; 46w; 46v) est telle qu'un espace formé par rapport au panneau de cellule solaire (20) est plus étroit sur la portion de pointe en comparaison avec une portion au milieu.

4. Module de cellule solaire (10) selon l'une quelconque des revendications 1 à 3, dans lequel la partie de bride (46; 46u; 46w; 46v) présente une face de pointe (49), laquelle est inclinée d'une manière telle qu'une face inférieure (48) s'étend plus en longueur qu'une face supérieure (47).
